# EUROPEAN PATENT SPECIFICATION

(11) **EP 0 488 440 B1**
(45) Date of publication and mention of the grant of the patent: **13.03.1996**
(21) Application number: 91202986.5
(22) Date of filing: 16.11.1991
(51) Int. Cl.: H01L 21/265, H01L 21/22, H01L 29/167

(54) **Process of introduction and diffusion of platinum ions in a slice of silicon**
Verfahren zur Einführung und Diffundierung von Platin-Ionen in einem Siliziumplättchen
Procédé d'introduction et de diffusion d'ions platine dans une tranche de silicium

(30) Priority: 29.11.1990 IT 2223790
(43) Date of publication of application: 03.06.1992
(73) Proprietor: CONSORZIO PER LA RICERCA SULLA MICROELETTRONICA NEL MEZZOGIORNO, I-95121 Catania (IT)
(72) Inventor: Frisina, Ferruccio, I-95123 Catania (IT); Tavolo, Nella, I-95048 Scordia, Catania (IT); Raspagliesi, Mario, I-95037 San Giovanni la Punta, Catania (IT)
(74) Representative: Mittler, Enrico

(56) References cited:
- FR-A- 2 241 141
- US-A- 4 620 211
- US-A- 4 717 588
- US-A- 4 855 799
- PATENT ABSTRACTS OF JAPAN vol. 81, no. 85 (E-262) 24 August 1984 ; & JP-A-59 075 662
- PATENT ABSTRACTS OF JAPAN vol. 11, no. 249 (E-532) 13 August 1987 ; & JP-A-62 062 557

## Description

The present invention relates to a process of introduction and diffusion of platinum ions in a slice of silicon comprising semiconductor devices.

The need to reduce the lifetime of minority carriers in semiconductor devices derives from different application needs for each type of device: power MOSFET's, fast diodes, IGBT's, bipolar power transistors, thyristors.

In any case the object is that of reducing the quenching times of the device thus reducing its energy losses during switching, without worsening its static characteristics.

The techniques used most commonly to reduce the lifetime of minority carriers in semiconductor devices are the deposition of gold, the deposition of platinum and electron radiation.

The deposition of gold is frequently used but it produces two undesired effects. First of all it causes a considerable increase in the leakage current, especially with increasing temperatures. Also, it causes a substantial increase in the resistivity of the silicon.

As far as electron radiation is concerned, although it does not cause high leakage currents, it does create considerable damage to the Si-SiO₂ interface, which shows up as a lowering of the threshold voltage for MOS devices. It can also be sensitive to thermal processes at low temperature (equal to, say, 400 - 500°C) such as the process for attaching the die to its support, normally called die attach.

The deposition of platinum offers several advantages.

In fact, this has a low leakage current, stability to thermal processes at low temperature (below 700°C), and in addition, compared with the process that uses the deposition of gold, it has lower variations in the resistivity of the silicon.

The process currently in use according to the known art consists in the introduction of platinum in the slice of silicon through a process of deposition on the rear of the slice followed by a process of diffusion at a temperature of some 900°C.

With this process during the diffusion a thin layer of silicon oxide is formed which stops the further diffusion of the platinum itself.

A first method for eliminating the layer of silicon oxide provides for the deposition of platinum to be preceded by the deposition over the surface of the semiconductor of a layer of palladium, which has the purpose of facilitating the diffusion of the platinum. As an alternative the formation is provided for at the Si-Pt interface of platinum silicides suitable for encouraging the diffusion of the platinum in the semiconductor. Both methods are described in the US patent No. 4,925,812.

In any case, even when more complicated processes are used, the process of deposition of platinum has substantial limitations.

In the first place, the quantity of platinum diffused inside the silicon is determined by the thermal diffusion process and by the solid solubility of the platinum in the silicon.

In the second place, since the concentration of platinum is equal to the solid solubility, the surface behaves as an infinite source and the distribution of platinum along the length of the slice is highly uneven.

Lastly, the deposition of platinum can be executed only on the rear of the slice of semiconductor and it does not allow the introduction of platinum in silicon areas bounded by masking.

In the case wherein it is desired to execute the deposition of platinum in well-defined areas on the front of the slice, such deposition is not possible according to the known art.

FR-A-2241141 discloses a method for controlling the carrier lifetime in a semiconductor body, which comprises implant and diffusion of platinum ions into a silicon slice provided with on junctions. The diffusion step is executed in an atmosphere of inert gas such as hydrogen.

The object of the present invention is to overcome the described drawbacks with a process which allows the introduction in a slice of semiconductor material, from the rear or from the front at areas well-defined by masking, of a controlled quantity of platinum ions, that is lower than the solid solubility, and its distribution in a uniform manner inside the slice of material and over the entire slice itself, so as to obtain resistivity profiles that are constant along the entire thickness and surface of the slice of semiconductor.

Another object is that of manufacturing semiconductor devices with enhanced characteristics and dynamics.

According to the invention such objects are attained by means of a process as defined in claim 1.

According to one of its possible embodiments the process according to the invention provides for the implant of the platinum ions to be executed on the rear of the slice of silicon and before the formation of the contacts and of the metallization step.

As an alternative, the process according to the invention provides for the implant of the platinum ions to be executed on the front of the slice of silicon after the formation of the contacts and before the metallization step.

In this way it is possible to introduce into the silicon a perfectly controlled and defined quantity of platinum, operating from the rear or from the front of the slice of silicon in areas that are perfectly defined by masking. In case the ionic implant is executed from the rear the distribution of platinum obtained is perfectly uniform (with no discontinuities) over the entire surface of a slice having a size from 10 to 20 cm (4 to 8 inches). It has also been shown experimentally that, in the case of ionic implant, all the devices in the slice itself receive the same quantity of platinum ions.

There follows a diffusion at a temperatuyre ranging from 850°C to 1000°C in a nitrogen atmosphere to prevent part of the platinum from «evaporating» from the surface. It has in fact been found that a surface «nitridization» takes place that freezes the platinum inside the silicon.

The diffusion temperature is such as to have no effect at all on the junctions already formed in the silicon, whose depth remains totally unchanged.

The process according to the invention can be accomplished, for example, with the equipment described in the Italian patent application No. 19134 A/90 dated 23 January 1990.

The use of the process according to the invention, especially suitable for power MOS and IGBT devices but also applicable to bipolar structures, has several advantages over the techniques commonly used:
a) it subtantially simplifies the process steps;
b) it allows the introduction, with a very high uniformity on a slice, of a perfectly controlled quantity of platinum ions that is lower than the solid solubility; this means a finite source of platinum ions at the surface, the only one that makes it possible to obtain perfectly «flat» concentration profiles along the thickness of the slice;
c) when the ionic implant is executed from the rear, it allows a uniform distribution of platinum to be obtained over the entire surface of a slice having a size from 10 to 20 cm (4 to 8 inches);
d) lastly, it has the advantage that it introduces the platinum ions also from the front of the slice through masking windows.

The features of the present invention shall be made more evident by its embodiments illustrated as a non-limiting example in the enclosed drawings, wherein:
Fig.s 1 - 3 illustrate an embodiment of the process according to the invention;

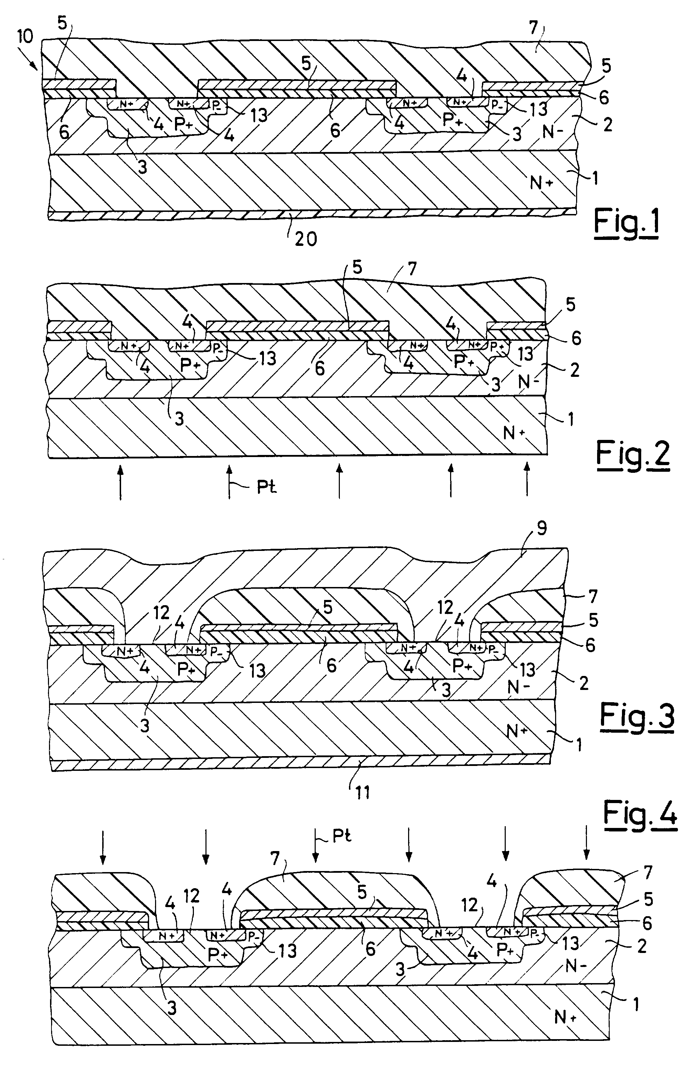

Fig. 4 illustrates process steps that are alternatives to those illustrated in Fig. 2.

With reference to Fig. 1, this summarizes all the process steps up to the accomplishment of a semiconductor device of the power MOS type indicated as a whole with 10.

These comprise in particular the formation, on a substrate 1 of silicon having a high doping of the type N+, of an epitaxial layer 2 of the type N- having a high resistivity (from 20 to 100 ohm cm).

On the epitaxial layer 2 body regions 3 of the type P+ and, inside each region 3 of the type P+, a pair of regions of the type N+ and a pair of channel regions 13 of the type P-have then been formed.

Over the epitaxial layer 2, between each pair of body regions 3 and with the interposition of gate oxide 6, there is superimposed a layer of polysilicon 5 constituting the gate electrode.

Over the entire upper surface or front of the device there has lastly been deposited a passivating oxide 7, that has the task of separating the gate electrodes 5 from the subsequent source metallization.

At this point all the thermal processes at high temperature have been executed.

As illustrated in Fig. 2, the process according to the invention now provides for the execution on the rear of the substrate 1 of a chemical etching for the removal of a layer of oxide 20 that has inevitably grown on the lower surface or rear of the substrate 1, followed by an implant of platinum ions (Pt) with an energy of 40 KeV with a dose that varies, according to the devices, from 1E12 atoms/cm to 1E14 atoms/cm. The selection of the dose depends on the value of the desired lifetime of the minority carriers and on the resistivity of the epitaxial layer 2 of type N-.

A perfect dependence has in fact been found between implant dose and lifetime; moreover, the introduction of platinum in silicon increases its resistivity. Such increment is larger with a high starting resistivity and with a high quantity of platinum introduced.

After the Pt implant process there follows a diffusion in a nitrogen atmosphere at a temperature ranging from 850°C to 1000°C and for a time ranging between 1h and 10h. The temperature and the time of diffusion are such as not to alter the depths of the junctions already accomplished.

There then follows, as illustrated in Fig. 3, the opening of the contacts by etching of the passivating oxide 7 for the definition of windows 12 giving access to the underlying source regions 4. The oxide 7 remains only to insulate completely the gate electrodes 5 from a further layer of source metallization 9 subsequently deposited over the entire surface of the device. A further metallization layer 11 is subsequently deposited on the rear of the substrate 1 for the drain metallization.

According to an alternative embodiment, starting from the situation illustrated in Fig. 1, the passivating oxide 7 is then etched at areas 12 giving access to the source regions 4. Such etching is followed, as illustrated in Fig. 4, by the implant of platinum on the front of the device in the direction indicated by the arrows, and by its subsequent diffusion in the device.

Such steps are followed by the deposition of the metallizations 9, 11 in a manner altogether similar to the one illustrated, according to the first embodiment, in Fig. 3.

In general terms it should be noted that the quantity of platinum ions implanted both from the rear and from the front and distributed inside the silicon, due to the particular diffusion mechanism, tends to be distributed preferably over the surfaces.

When the Pt source is infinite, as in the case of the deposition of Pt, the concentration profile is a perfectly symmetrical U-shaped profile.

To obtain flat concentration profiles very long diffusion times are then necessary (from 10 to 20 hours) and the concentration cannot be controlled, but it does depend on the solid solubility at the diffusion temperature.

When the Pt implant according to the invention is used, the concentration profile still has a U-shape but it is possible to arrange for the number of implanted atoms be lower than the value of the solid solubility at the diffusion temperature.

In practice this accomplishes a finite source of Pt and the distribution along the thickness of the slice is already constant even for very short times (from 0.5 to 2 hours) and the concentration is determined by the implant dose.

Since the resistivity of the silicon is increased by the concentration of Pt (in a manner proportional to the concentration of Pt and to the resistivity of the silicon), it follows that the profiles of resistivity also follow those of the concentration.

Thus the invention allows the introduction, even for high resistivities (about 20ö100 ohm cm), of high concentrations of Pt in the silicon (10¹⁵ö10¹⁷ Pt/cm³) obtaining perfectly flat and controlled resistivity profiles along the thickness of the slice of silicon.

It has been found that this gives the best performance of the device in terms of output resistance and switching losses.

It has also been found that, in the case of ionic implant, all the devices in the slice receive the same quantity of silicon ions.

## Claims

1. Process of manufacturing a semiconductor device with reduced Lifetime of minority carriers, comprising subjecting a silicon slice to a succession of thermal steps at high temperature, introduction of platinum ions into the slice by ionic implant and diffusion, and subsequent steps for opening contacts and for surface metalization, characterized in that the diffusion of platinum is executed in a nitrogen atmosphere for a time sufficient to obtain a resistivity profile which is constant throughout the thickness of the silicon slice.

2. Process according to claim 1, characterized in that the implant of platinum ions is executed on the rear of the silicon slice before the formation of the contacts and the metalization step.

3. Process according to claim 1, characterized in that the implant of platinum ions is executed on the front of the silicon slice after the formation of the contacts and before the metalization step.

4. Process according to claim 1, characterized in that the implant of platinum ions is executed with a dose lower than the semiconductor solid solubility at the diffusion temperature.

5. Process according to claim 4, characterized in that said dose ranges from 1E12 atoms/cm to 1E14 atoms/cm.

6. Process according to claim 1, characterized in that the time of diffusion ranges from 1 to 10 hours.

7. Process according to claim 1, characterized in that said semiconductor device is a power MOS device.

8. Process according to claim 1, characterized in that said semiconductor device is an IGBT (Isolated Gate Bipolar Transistor) device.

## Patentansprüche

1. Verfahren zum Herstellen eines Halbleiterbauelements mit verringerter Minoritätsladungsträger-Lebensdauer, bei dem eine Siliziumscheibe nacheinander thermischen Hochtemperatur-Schritten ausgesetzt wird, in die Scheibe durch Inonenimplantation und Diffusion Platinionen eingebracht werden, und anschließende Schritte zum Öffnen von Kontakten und zur Oberflächenmetallisierung folgen, **dadurch gekennzeichnet**, daß die Diffusion von Platin in einer Stickstoffatmosphäre während einer Zeit ausgeführt wird, die ausreicht, um ein Widerstandsprofil zu erreichen, welches über die Dicke der Siliziumscheibe konstant ist.

2. Verfahren nach Anspruch 1, **dadurch gekennzeichnet**, daß die Implantierung von Platinionen auf der Rückseite der Siliziumscheibe vor der Bildung der Kontakte und dem Metallisierungsschritt durchgeführt wird.

3. Verfahren nach Anspruch 1, **dadurch gekennzeichnet**, daß die Implantierung von Platinionen auf der Vorderseite der Siliziumscheibe nach der Bildung der Kontakte und vor dem Metallisierungsschritt durchgeführt wird.

4. Verfahren nach Anspruch 1, **dadurch gekennzeichnet**, daß das Implantieren von Platinionen mit einer Dosis erfolgt, die geringer ist als die Halbleiter-Feststofflöslichkeit bei der Diffusionstemperatur.

5. Verfahren nach Anspruch 4, **dadurch gekennzeichnet**, daß die Dosis von 1E12 Atomen/cm bis 1E14 Atomen/cm reicht.

6. Verfahren nach Anspruch 1, **dadurch gekennzeichnet**, daß die Diffusionszeit von 1 bis 10 Stunden reicht.

7. Verfahren nach Anspruch 1, **dadurch gekennzeichnet**, daß das Halbleiterbauelement ein Leistungs-MOS-Bauelement ist.

8. Verfahren nach Anspruch 1, **dadurch gekennzeichnet**, daß das Halbleiterbauelement ein IBGT-Bauelement (ein Bipolartransistor mit isoliertem Gate) ist.

## Revendications

1. Procédé de fabrication d'un dispositif semiconducteur à durée de vie réduite des porteurs minoritaires, consistant à soumettre une tranche de silicium à une succession d'étapes thermiques à haute température, à introduire des ions platine dans la tranche par implantation ionique et diffusion, et comprenant en outre des étapes ultérieures d'ouverture de contacts et de métallisation superficielle, caractérisé en ce que la diffusion de platine est exécutée sous atmosphère d'azote pendant une durée suffisante pour obtenir un profil de résistivité sensiblement constant sur l'épaisseur de la tranche de silicium.

2. Procédé selon la revendication 1, caractérisé en ce que l'obtention des ions platine est exécutée sur la face arrière de la tranche de silicium avant formation des contacts et avant l'étape de métallisation.

3. Procédé selon la revendication 1, caractérisé en ce que l'implantation d'ions platine est exécutée sur la face avant de la tranche de silicium après formation des contacts et avant l'étape de métallisation.

4. Procédé selon la revendication 1, caractérisé en ce que l'implantation des ions platine est exécutée sous une dose inférieure à la solubilité solide du semiconducteur pour la température de diffusion.

5. Procédé selon la revendication 4, caractérisé en ce que ladite dose est située dans une plage de 10¹ à 10¹⁴ atomes/cm .

6. Procédé selon la revendication 1, caractérisé en ce que la durée de la diffusion est comprise entre 1 et 10 heures.

7. Procédé selon la revendication 1, caractérisé en ce que le dispositif semiconducteur est un dispositif MOS de puissance.

8. Procédé selon la revendication 1, caractérisé en ce que le dispositif semiconducteur est un dispositif IGBT (transistor bipolaire à grille isolée).
